# EUROPEAN PATENT APPLICATION

(11) **EP 1 467 494 A2**
(43) Date of publication of application: **13.10.2004**
(21) Application number: 04006248.1
(22) Date of filing: 16.03.2004
(51) Int. Cl.: H04B 1/10

(54) **Television tuner**

(30) Priority: 09.04.2003 JP 2003001954 U
(71) Applicant: ALPS ELECTRIC CO., LTD., Tokyo 145-8501 (JP)
(72) Inventor: Yamamoto, Masaki, c/o Alps Electric co., Ltd., Tokyo 145-8501 (JP)
(74) Representative: Klunker . Schmitt-Nilson . Hirsch

(57) **Abstract**

An object of the present invention is to prevent audio quality from deteriorating even if a television signal of a SECAM format is received using a television tuner of a PAL format that attenuates an audio intermediate signal in an adjacent channel.

The television tuner of the present invention comprises a mixer 1 for converting a selected television signal into an intermediate frequency signal; an intermediate frequency amplifier 2 for amplifying the intermediate frequency signal; and a trap circuit 4 for switching an attenuated frequency interposed between the mixer 1 and the intermediate frequency amplifier 2, wherein an audio intermediate frequency signal in an adjacent channel of a PAL format or a video intermediate frequency signal in an adjacent channel of a SECAM format is attenuated by the trap circuit 4. Therefore, when a television signal of any format is received, it is possible to receive the television signal without interference due to the audio intermediate frequency signal or the video intermediate frequency signal in the adjacent channel without attenuating the video intermediate frequency signal and the audio intermediate frequency signal.

## Description

### BACKGROUND OF THE INVENTION

### 1. Field of the Invention

The present invention relates to a television tuner capable of receiving television signals in PAL and SECAM formats.

### 2. Description of the Related Art

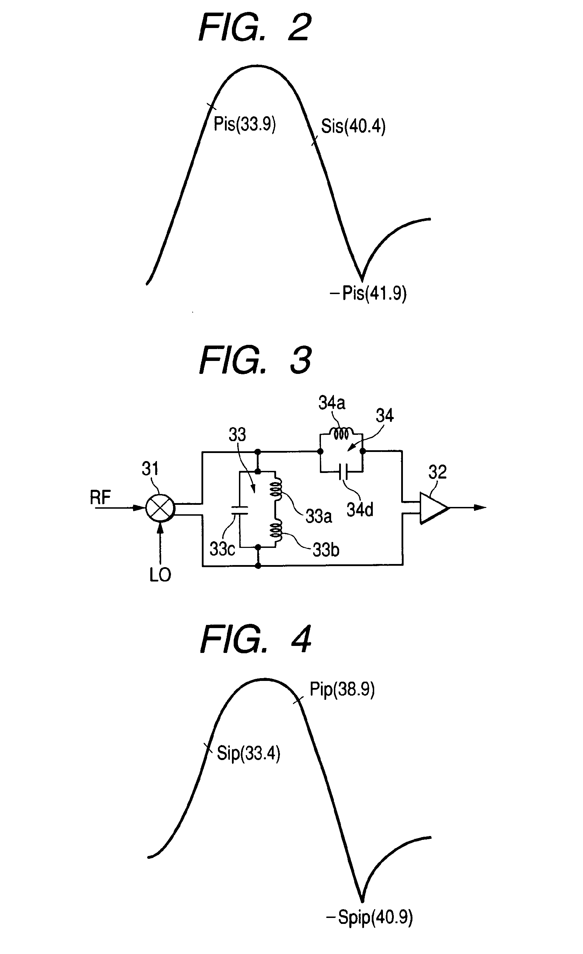

As illustrated in Fig. 3, a conventional television tuner includes a mixer 31 for mixing a received television signal RF with a local oscillation signal LO to convert the mixed signal into an intermediate frequency signal, an intermediate frequency amplifier 32 for amplifying the intermediate frequency signal, an intermediate frequency tuning circuit 33 interposed between the mixer 31 and the intermediate frequency amplifier 32, and a trap circuit 34. The mixer 31 and the intermediate frequency amplifier 32 are balanced ones. The intermediate frequency tuning circuit 33 is connected between the balanced output ends of the mixer 31. The trap circuit 34 is connected between one output end of the mixer 31 and one input end of the intermediate frequency amplifier 32. The other output end of the mixer is connected to the other input end of the intermediate frequency amplifier 32.

The intermediate frequency tuning circuit 33 comprises a parallel tuning circuit that includes two serially connected inductance elements 33a and 33b and a capacitance element 33c connected to the two inductance elements 33a and 33b in parallel and is tuned between a video intermediate frequency (Pip = 38.9 MHz) and an audio intermediate frequency (Sip = 33.4 MHz) in PAL format. The trap circuit 34 also comprises a parallel resonance circuit including an inductance element 34a and a capacitance element 34b and resonates in parallel around the audio intermediate frequency (-Sip = 40.9 MHz) in an adjacent channel.

Therefore, as illustrated in Fig. 4, the frequency characteristic of the input end of the intermediate frequency amplifier 32 attenuates around the audio intermediate frequency (-Sip) of the adjacent channel so as not to be disturbed by an audio intermediate frequency signal of the adjacent channel.

On the other hand, the wavecrests are reversed in a video intermediate frequency (Pis = 33.9 MHz) and an audio intermediate frequency (Sis = 40.4 MHz) in an intermediate frequency band of the SECAM format and a video intermediate frequency (Pip = 38.9 MHz) and an audio intermediate frequency (Sip = 33.4 MHz) in an intermediate frequency band of a PAL format. However, since the intermediate frequency band of the SECAM format overlaps the intermediate frequency band of the PAL format in a significant range, a television receiver capable of receiving the television signals of both of the PAL format and the SECAM format using a television tuner of the PAL format is manufactured. However, since the audio intermediate frequency (Sis = 40.4 MHz) of the SECAM format is extremely close to the frequency (-Sip = 40.9 MHz) attenuated by the trap circuit 34, when the television signal of the SECAM format is received, the quality of the audio deteriorates.

### SUMMARY OF THE INVENTION

It is an object of the present invention to prevent audio quality from deteriorating even if a television signal of a SECAM format is received using a television tuner of a PAL format that attenuates an audio intermediate signal in an adjacent channel.

To achieve the above object, there is provided a television tuner, comprising a mixer for converting a selected television signal into an intermediate frequency signal; an intermediate frequency amplifier for amplifying the intermediate frequency signal; and a trap circuit for switching an attenuated frequency interposed between the mixer and the intermediate frequency amplifier, wherein an audio intermediate frequency signal in an adjacent channel of a PAL format or a video intermediate frequency signal in an adjacent channel of a SECAM format is attenuated by the trap circuit.

In addition, the television tuner according to the present invention further comprises a switch diode for converting the attenuated frequency provided in the trap circuit; and a switch transistor provided in an integrated circuit, wherein the mixer and the intermediate frequency amplifier are provided in the integrated circuit to form the integrated circuit,
wherein an output terminal connected to the output end of the mixer and an input terminal connected to the input end of the intermediate frequency amplifier are provided in the integrated circuit, wherein the trap circuit is connected between the output terminal and the input terminal, and wherein the switch diode is controlled to on or off using the switch transistor.

In addition, the mixer and the intermediate frequency amplifier are formed in a balanced output type and a balanced input type, respectively, the output terminal and the input terminal are provided two by two, respectively, an intermediate frequency tuning circuit tuned to the intermediate frequency signal is connected between the output terminals, the trap circuit is connected between one output terminal and one input terminal, the other output terminal and the other input terminal are connected to each other, power is supplied to the mixer and the anode of the switch diode through the intermediate frequency tuning circuit, and the cathode of the switch diode and the collector of the switch transistor is connected to one input terminal.

The trap circuit comprises a series connecting circuit of an inductance element and a first capacitance element, and a second capacitance element connecting in parallel the series connecting circuit, wherein the switch diode is connected in parallel to the first capacitance element.

### BRIEF DESCRIPTION OF THE DRAWINGS

Fig. 1 is a circuit diagram illustrating the structure of a television tuner according to the present invention;
Fig. 2 is a view illustrating the frequency characteristic of an intermediate frequency band when a television signal of a PAL format is received by the television tuner according to the present invention;
Fig. 3 is a view illustrating the frequency characteristic of an intermediate frequency band when a television signal of a SECAM format is received by the television tuner according to the present invention; and
Fig. 4 is a circuit diagram illustrating the structure of a conventional television tuner.

### [Reference Numerals]

- 1:: MIXER
- 2:: INTERMEDIATE FREQUENCY AMPLIFIER
- 3:: INTERMEDIATE FREQUENCY TUNING CIRCUIT
- 3a, 3b:: INDUCTANCE ELEMENT
- 3c:: CAPACITANCE ELEMENT
- 4:: TRAP CIRCUIT
- 4a:: INDUCTANCE ELEMENT
- 4b:: FIRST CAPACITANCE ELEMENT
- 4c:: SECOND CAPACITANCE ELEMENT
- 4d:: SWITCH DIODE
- 10:: INTEGRATED CIRCUIT
- 10a, 10b:: OUTPUT TERMINAL
- 10c, 10d:: INPUT TERMINAL
- 11:: SWITCH TRANSISTOR
- 12:: POWER SUPPLY RESISTOR
- 13:: RESISTOR

### DESCRIPTION OF THE PREFERRED EMBODIMENTS

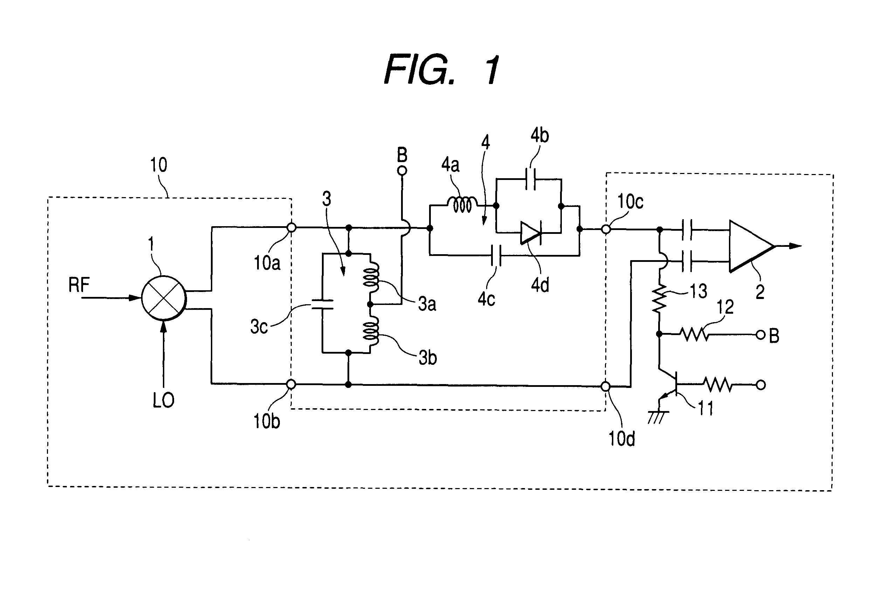

Fig. 1 illustrates the structure of a television tuner according to the present invention. The television tuner according to the present invention comprises a mixer 1 for mixing a received television signal RF with a local oscillation signal LO to convert the mixed signal into an intermediate frequency signal, an intermediate frequency amplifier 2 for amplifying the intermediate frequency signal, an intermediate frequency tuning circuit 3 interposed between the mixer 1 and the intermediate frequency amplifier 2, and a trap circuit 4. The mixer 1 and the intermediate frequency amplifier 2 are balanced ones provided in an integrated circuit 10. The intermediate frequency tuning circuit 3 and the trap circuit 4 are provided outside the integrated circuit 10.

The integrated circuit 10 includes a pair of output terminals 10a and 10b of one band, which are connected to the balanced output ends of the mixer 1. The intermediate frequency tuning circuit 3 is connected between the output terminals 10a and 10b. The intermediate frequency tuning circuit 3 includes two serially connected inductance elements 3a and 3b and a capacitance element 3c connected to the two inductance elements 3a and 3b in parallel and is tuned between a video intermediate frequency (Pip = 38.9 MHz) and an audio intermediate frequency (Sip = 33.4 MHz) in an intermediate frequency band of a PAL format in parallel. A power supply voltage B applied to the connection point of the two inductance elements 3a and 3b and is supplied to the mixer 1.

A pair of input terminals 10c and 10d connected to the balanced input ends of the intermediate frequency amplifier 2 are provided in the integrated circuit 10. The trap circuit 4 is connected between one output terminal 10a and one input terminal 10c. The other output terminal 10b and the other input terminal 10d are connected to each other.

The trap circuit 4 includes a series connecting circuit of an inductance element 4a and a first capacitance element 4b, a second capacitance element 4c connected to all of the inductance element and the first capacitance element in parallel, and a switch diode 4d connected to the first capacitance element 4b in parallel. The cathode of the switch diode 4d is connected to one input terminal 10c. Therefore, a power supply voltage is applied to the anode of the switch diode 4d through the intermediate frequency tuning circuit 3.

When the switch diode 4d is switched on, the trap circuit 4 resonates in parallel around an audio intermediate frequency (-Sip = 40.9 MHz) in an adjacent channel of the PAL format by the inductance element 4a and the second capacitance element 4c. When the switch diode 4d is switched off, the trap circuit 4 resonates in parallel in a video intermediate frequency (-Pis = 41.9 MHz) in an adjacent channel of the SECAM format. At the same time, the trap circuit serially resonates between a video intermediate frequency (Pis = 33.9 MHz) and an audio intermediate frequency (Sis = 40.4 MHz) in the intermediate frequency band of the SECAM format.

A switch transistor 11 is provided in the integrated circuit 10. The emitter of the switch transistor 11 is grounded and the collector of the switch transistor is pulled up to the power supply voltage by the power supply resistor 12. The collector of the switch transistor 11 is connected to one input terminal 10c through a resistor 13.

In the above-mentioned structure, when the television signal of the PAL format is received, the switch transistor 11 is switched on. Then, the switch diode 4d is also switched on and the trap circuit 4 resonates in parallel in 40.9 MHz. Therefore, the frequency characteristic in the input end of the intermediate frequency amplifier 2 is as illustrated in Fig. 4 to reduce interference due to an audio intermediate frequency signal in an adjacent channel.

When the television signal of the SECAM format is received, since the switch transistor 11 is switched off, the switch diode 4d is also switched off. Therefore, since the trap circuit 4 resonates in parallel in a video intermediate frequency (-Pis = 41.9 MHz) in an adjacent channel of the SECAM format, the frequency characteristic in the input end of the intermediate frequency amplifier 2 attenuates in a video intermediate frequency (-Pis = 41.9 MHz) in an adjacent channel as illustrated in Fig. 2 to reduce interference due to the video intermediate frequency signal of the adjacent channel.

At this time, the trap circuit 4 serially resonates between a video intermediate frequency (Pis = 33.9 MHz) and an audio intermediate frequency (Sis = 40.4 MHz) in the SECAM format and the intermediate frequency tuning circuit 3 also resonates in parallel between a video intermediate frequency (Pip = 38.9 MHz) and an audio intermediate frequency (Sip = 33.4 MHz) in the PAL format. Therefore, the intermediate frequency signal of the SECAM format is not attenuated.

As mentioned above, a television tuner of the present invention comprises a mixer for converting a selected television signal into an intermediate frequency signal; an intermediate frequency amplifier for amplifying the intermediate frequency signal; and a trap circuit for switching an attenuated frequency interposed between the mixer and the intermediate frequency amplifier, wherein an audio intermediate frequency signal in an adjacent channel of a PAL format or a video intermediate frequency signal in an adjacent channel of a SECAM format is attenuated by the trap circuit. Therefore, when a television signal of any format is received, it is possible to receive the television signal without interference due to an audio intermediate frequency signal or a video intermediate frequency signal in an adjacent channel without attenuating the video intermediate frequency signal and the voice intermediate frequency signal.

In addition, the television tuner according to the present invention further comprises a switch diode for converting the attenuated frequency provided in the trap circuit; and a switch transistor provided in an integrated circuit, wherein the mixer and the intermediate frequency amplifier are provided in the integrated circuit to form the integrated circuit, wherein an output terminal connected to the output end of the mixer and an input terminal connected to the input end of the intermediate frequency amplifier are provided in the integrated circuit, wherein the trap circuit is connected between the output terminal and the input terminal, and wherein the switch diode is controlled to on or off using the switch transistor. Therefore, it is possible to simply convert the attenuated frequency without providing particular parts outside the integrated circuit.

Further, the mixer and the intermediate frequency amplifier are formed in a balanced output type and a balanced input type, respectively, the output terminal and the input terminal are provided two by two, respectively, an intermediate frequency tuning circuit tuned to the intermediate frequency signal is connected between the output terminals, the trap circuit is connected between one output terminal and one input terminal, the other output terminal and the other input terminal are connected to each other, power is supplied to the mixer and the anode of the switch diode through the intermediate frequency tuning circuit, and the cathode of the switch diode and the collector of the switch transistor is connected to one input terminal. Therefore, it is possible to simply switch on or off the switch diode for converting the attenuated frequency.

In addition, The trap circuit comprises a series connecting circuit of an inductance element and a first capacitance element, and a second capacitance element connecting in parallel the series connecting circuit, wherein the switch diode is connected in parallel to the first capacitance element. Therefore, it is possible to attenuate the audio intermediate frequency in the adjacent channel of the PAL format or the video intermediate frequency in the adjacent channel of the SECAM format by switching the switch diode on or off.

## Claims

1. A television tuner, comprising:
a mixer for converting a selected television signal into an intermediate frequency signal;
an intermediate frequency amplifier for amplifying the intermediate frequency signal; and
a trap circuit for switching an attenuated frequency interposed between the mixer and the intermediate frequency amplifier,
wherein an audio intermediate frequency signal in an adjacent channel of a PAL format or a video intermediate frequency signal in an adjacent channel of a SECAM format is attenuated by the trap circuit.

2. The television tuner according to Claim 1, further comprising a switch diode for converting the attenuated frequency provided in the trap circuit; and
a switch transistor provided in an integrated circuit,
wherein the mixer and the intermediate frequency amplifier are provided in the integrated circuit to form the integrated circuit,
wherein an output terminal connected to the output end of the mixer and an input terminal connected to the input end of the intermediate frequency amplifier are provided in the integrated circuit,
wherein the trap circuit is connected between the output terminal and the input terminal, and
wherein the switch diode is controlled to on or off using the switch transistor.

3. The television tuner according to Claim 2,
wherein the mixer and the intermediate frequency amplifier are formed in a balanced output type and a balanced input type, respectively,
wherein the output terminal and the input terminal are provided two by two, respectively,
wherein an intermediate frequency tuning circuit tuned to the intermediate frequency signal is connected between the output terminals,
wherein the trap circuit is connected between one output terminal and one input terminal,
wherein the other output terminal and the other input terminal are connected to each other,
wherein power is supplied to the mixer and the anode of the switch diode through the intermediate frequency tuning circuit, and
wherein the cathode of the switch diode and the collector of the switch transistor is connected to one input terminal.

4. The television tuner according to Claim 2 or 3,
wherein the trap circuit comprises a series connecting circuit of an inductance element and a first capacitance element, and a second capacitance element connecting in parallel the series connecting circuit,
wherein the switch diode is connected in parallel to the first capacitance element.
